# EUROPEAN PATENT APPLICATION

(11) **EP 1 147 905 A1**
(43) Date of publication of application: **24.10.2001**
(21) Application number: 99954377.0
(22) Date of filing: 05.11.1999
(51) Int. Cl.: B41J 2/385, H05K 3/28, H05K 3/00

(54) **METHOD OF MANUFACTURING PRINTED-CIRCUIT BOARD, METHOD OF MANUFACTURING RECORDING DEVICE, AND MASK FOR PRINTED-CIRCUIT BOARD**

(30) Priority: 05.11.1998 JP 31490798; 10.11.1998 JP 31910298
(71) Applicant: MATSUSHITA ELECTRIC INDUSTRIAL CO., LTD., Kadoma-shi, Osaka 571-8501 (JP); ARRAY AB, 421 57 Västra Frölunda (SE)
(72) Inventor: AIZAWA, Masahiro, Takatsuki-shi, Osaka 569-0002 (JP); TSUJIMOTO, Takahiro, Moriguchi-shi, Osaka 570-0015 (JP); MIURA, Masayoshi, Kawasaki-shi, Osaka 214-0036 (JP); TATEKAWA, Masaichiro, Minoo-shi, Osaka 562-0001 (JP)
(74) Representative: Grünecker, Kinkeldey, Stockmair & Schwanhäusser Anwaltssozietät
(86) International application number: JP9906144
(87) International publication number: WO0027641

(57) **Abstract**

A control electrode (14) and a deflecting electrode (16) are respectively formed on both faces of an insulating substrate (25), and an insulating protection layer (28) is formed thereon. A holing process for forming a passing hole (13) is carried out through the protection layer (28) formed on the top face of the insulating substrate (25) by using a punch (50) with a diameter d2 larger than the inner diameter d0 of the control electrode (14). Thereafter, exposed portions (19) of the control electrode (14) and the deflecting electrode (16) are etched in a radial direction of the passing hole (13). Then, opening edges (18) of the protection layer (28) are bent toward the insulating substrate (25), so as to cover the control electrode (14) and the deflecting electrode (16).

## Description

### Technical Field

The present invention relates to a method for fabricating a printed substrate usable as a developer passage control substrate utilized in, for example, a toner jet (trademark) recording apparatus and a variety of electronic circuit substrates, a method for fabricating a recording apparatus including the printed substrate and a mask suitably used for fabricating the printed substrate in these fabrication methods.

### Background Art

As a control substrate for controlling passage of a charged substance such as a charged toner and an ion current, a printed substrate including an insulating substrate **104** having a passing hole **103** and electrodes **108** that are buried around the passing hole **103** and have no exposed portion on the inner wall of the passing hole **103** as shown in FIG. **18** is conventionally known. For example, Japanese Laid-Open Patent Publication No. 10-86433 discloses, as one of this type of printed substrates, a printed substrate for controlling toner passage in the so-called toner jet (trademark) recording apparatus.

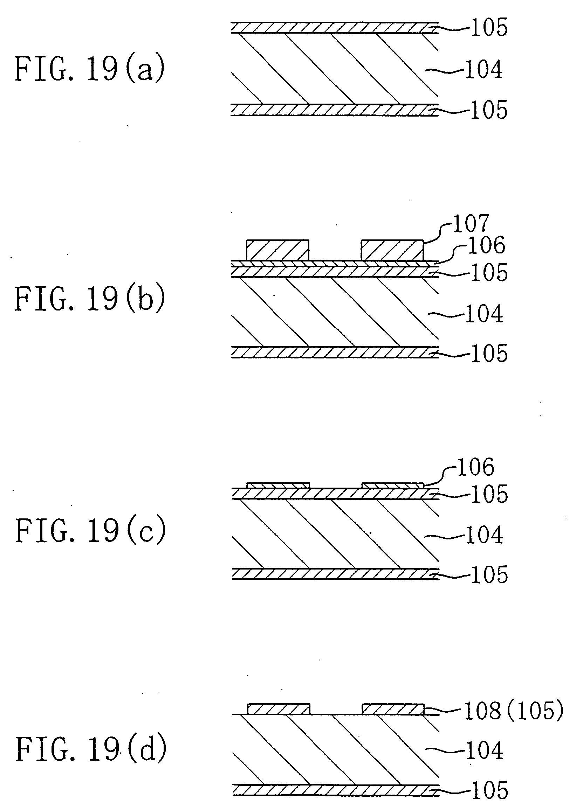

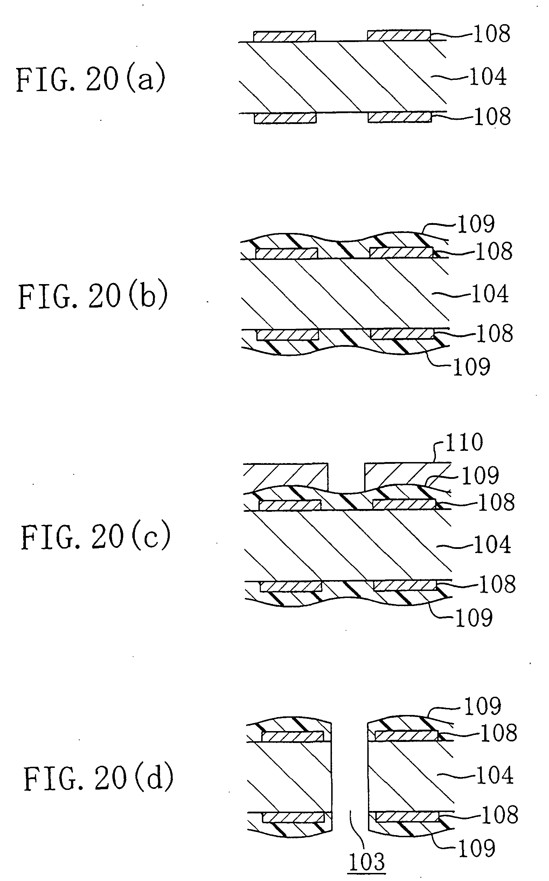

A method for fabricating a conventional printed substrate will be described with reference to FIGS. **19** and **20**. First, as shown in FIG. **19(a),** conducting layers **105** of copper foil are formed on both faces of an insulating substrate **104** of polyimide (first step). Next, as shown in FIG. **19(b),** a resist **106** is applied on the conducting layer **105** formed on the top face of the insulating substrate **104,** and a mask **107** is placed (second step). Thereafter, exposure is carried out through the mask **107**, so as to pattern the resist **106** as shown in FIG. **19(c)** (third step). With the resist **106** used as a mask, the conducting layer **105** is selectively removed by etching, so as to pattern the conducting layer **105** into an electrode **108** as shown in FIG. **19(d)** (fourth step).

Thereafter, the conducting layer **105** formed on the lower face of the insulating substrate **104** is similarly patterned into an electrode **108** as shown in FIG. **20(a)** (fifth step).

Next, polyimide is applied to the both faces of the insulating substrate **104** so as to form insulating layers **109** covering the electrodes **108** as shown in FIG. **20(b)** (sixth step). Then, a mask **110** is placed on the insulating layer **109** formed on the top face as shown in FIG. **20(c)** (seventh step). Thereafter, a holing process is carried out so as to form a passing hole **103** as shown in FIG. **20(d)** (eighth step).

In the conventional fabrication method, however, mask alignment required of high accuracy is necessary in at least three steps, that is, the second, fifth and seventh steps. In general, the diameter of the passing hole **103** is set to 70 through 120 *µ* m, the inner diameter of the electrode **108** is set to 150 through 160 *µ*m and the distance between the passing hole **103** and the electrode **108** is set to approximately 10 through 60 *µ*m. On the other hand, an error of approximately 20 *µ*m is generally caused in the mask alignment. Therefore, when the number of masks to be placed is large, an alignment error is not negligible.

Furthermore, polyimide used for forming the insulating layer **109** more easily shrinks and extends than copper used for forming the conducting layer **105,** and hence, the error can be further increased.

Accordingly, in order to improve the quality of a printed substrate, it is necessary to minimize the influence of a mask alignment error. In particular, when a printed substrate with a large area is to be fabricated through one process, the harmful effect of the mask alignment error is serious. Therefore, in order to suppress the harmful effect, the aforementioned steps can be carried out in each of plural blocks, which makes the process complicated and increases fabrication cost.

The present invention was devised in consideration of these problems, and an object is fabricating a printed substrate and a recording apparatus including the printed substrate at low cost and with ease by reducing the number of times of placing a mask at high accuracy.

### Disclosure of the Invention

In order to achieve the object, the invention employs, in forming a through hole, a method in which there is no need to accurately place a mask.

Furthermore, in order to achieve the object, the invention utilizes the same mask in formation of a through hole or recess and in formation of a conducting part or a resist for forming the conducting part.

Specifically, the method for fabricating a printed substrate according to the first aspect of the invention comprises a step of forming a through hole in a multi-layer substrate including at least first, second and third layers successively stacked; a step of etching a part of the second layer from an exposed portion thereof within the through hole in a radial direction of the through hole; and a covering step of covering the exposed portion of the second layer after etching.

In this manner, there arises no problem even when the through hole is slightly shifted in its position, and hence, there is no need to make a great effort in positioning the through hole. Therefore, the through hole can be formed without using a mask, and there is no need to place a mask at high accuracy in forming the through hole.

According to the second aspect of the invention, the covering step includes a step of bringing an opening edge of the first layer around the through hole and an opening edge of the third layer around the through hole into contact with each other, whereby covering the second layer in the first aspect.

In this manner, the exposed portion of the second layer is covered with part of the first or third layer, and hence, there is no need to form a protection layer for covering the second layer from another material.

According to the third aspect of the invention, the first and third layers are formed from insulating layers and the second layer is formed from a conducting layer in the first or second aspect.

In this manner, a structure in which a conducting layer is buried within an insulating layer can be obtained.

The method for fabricating a printed substrate according to the fourth aspect of the invention comprise the steps of, in a multi-layer substrate including a surface layer of a conducting layer and an insulating layer formed on a back face of the surface layer, patterning the surface layer with a part thereof remaining as a remaining portion; forming, in the multi-layer substrate, an extracted portion formed by extracting a part of the remaining portion and a recess or through hole corresponding to the extracted portion in the insulating layer by extracting the part of the remaining portion of the surface layer and a part or whole, along a thickness direction, of a portion of the insulating layer corresponding to the extracted portion; and covering at least the extracted portion of the surface layer and a wall of the recess or through hole of the insulating layer with an insulating layer.

Since the extracted portion of the surface layer and the recess or through hole of the insulating layer are simultaneously formed and the insulating layer for covering is provided thereafter, there is no need to place a mask at high accuracy.

The method for fabricating a printed substrate according to the fifth aspect of the invention comprises the steps of, in a multi-layer substrate including a surface layer of a conducting layer and an insulating layer formed on a back face of the surface layer, patterning the surface layer with a part thereof remaining as a remaining portion; forming, in the multi-layer substrate, an extracted portion by extracting a part of the remaining portion of the surface layer and a recess or through hole by extracting a part or whole, in a thickness direction, of a portion of the insulating layer corresponding to the extracted portion by using a mask having an opening smaller than the remaining portion; and covering at least the extracted portion of the surface layer and a wall of the recess or through hole of the insulating layer with an insulating layer.

In this manner, although the mask is used, since the extracted portion of the surface layer and the recess or through hole of the insulating layer are simultaneously formed and the insulating layer for covering is provided thereafter, there is no need to place a mask at high accuracy.

The method for fabricating a printed substrate according to the sixth aspect of the invention comprises the steps of, in a multi-layer substrate including a surface layer of a conducting layer and an insulating layer formed on a back face of the surface layer, patterning the surface layer with a part thereof remaining as a remaining portion; forming a through hole penetrating a part of the remaining portion of the surface layer and the insulating layer by punching processing; and covering at least the surface layer and a wall of the through hole of the insulating layer with an insulating layer.

In this manner, there is no need to place a mask at high accuracy.

The method for fabricating a printed substrate according to the seventh aspect of the invention comprises the steps of, in a multi-layer substrate including a surface layer of a conducting layer and an insulating layer formed on a back face of the surface layer, patterning the surface layer, whereby exposing a part of the insulating layer; forming a recess or through hole in an exposed portion of the insulating layer by using the patterned surface layer as a mask; and covering at least the surface layer and a wall of the recess or through hole with an insulating film by chemical vapor deposition.

In this manner, since the patterned surface layer is used as a mask, there is no need to place a mask at high accuracy. Also, since the chemical vapor deposition is employed in the step of covering with the insulating film, the insulating property can be kept even when the surface layer and the recess or through hole of the insulating layer are fine.

The method for fabricating a printed substrate according to the eighth aspect of the invention is a method for fabricating a printed substrate including a substrate having a through hole penetrating a top face and a back face thereof, a first control part provided on the top face of the substrate around at least a part of periphery of the through hole, a second control part provided on the back face of the substrate around at least a part of periphery of the through hole and a protection layer covering the first control part and the second control part, and comprises a control part setting step of providing the first control part on the top face of the substrate and providing the second control part on the back face of the substrate in a position corresponding to the first control part; a step of covering the control parts by providing the protection layer on the both faces of the substrate; a step of forming the through hole penetrating the substrate, the control parts and the protection layer; a step of etching a part of the control parts from an exposed portion thereof within the through hole in a radial direction of the through hole; and a covering step of covering the control parts with a protection layer after etching.

In this manner, there is no need to make a great effort in positioning the through hole, and there is no need to place a mask at high accuracy.

According to the ninth aspect of the invention, the covering step includes a step of bending opening edges around the through hole of the protection layer provided on the both faces of the substrate toward the substrate, whereby covering the first and second control parts with the opening edges in the eighth aspect.

In this manner, the exposed portions of the control parts are covered with a part of the protection layer, and hence, there is no need to form a protection member for covering the control parts from another material.

The method for fabricating a printed substrate according to the tenth aspect of the invention is a method for fabricating a printed substrate including a substrate having a through hole penetrating a top face and a back face thereof, a first control part provided on the top face of the substrate around at least a part of periphery of the through hole, a second control part provided on the back face of the substrate around at least a part of periphery of the through hole and a protection layer covering the first control part and the second control part, and comprises a control part setting step of providing the first control part on the top face of the substrate and providing the second control part on the back face of the substrate in a position corresponding to the first control part; a step of forming the through hole penetrating the substrate and the control parts; and a step of providing the protection layer on the control parts and a wall of the through hole of the substrate by chemical vapor deposition.

In this manner, there is no need to make a great effort in positioning the through hole, and hence, there is no need to place a mask at high accuracy. Also, since the protection layer is formed by the chemical vapor deposition, a good protection layer can be formed even when the through hole is fine.

The method for fabricating a printed substrate according to the eleventh aspect of the invention is a method for fabricating a printed substrate including a substrate having a through hole penetrating a top face and a back face thereof, a first control part provided on the top face of the substrate around at least a part of periphery of the through hole, a second control part provided on the back face of the substrate around at least a part of periphery of the through hole and a protection layer covering the first control part and the second control part, and comprises a control part setting step of providing the first control part in a ring or arch shape on the top face of the substrate and providing the second control part in a ring or arch shape on the back face of the substrate in a position corresponding to the first control part; a step of forming the through hole in the substrate by using a mask having an opening with an inner diameter smaller than an outer diameter of the ring or arch shape of the first control part; and a step of covering the control parts and a wall of the through hole of the substrate with the protection layer.

In this manner, although a mask is used, since the through hole is formed simultaneously in the control parts and the substrate and the protection layer is formed thereafter, there is no need to place a mask at high accuracy.

The method for fabricating a printed substrate according to the twelfth aspect of the invention is a method for fabricating a printed substrate including a substrate having a through hole penetrating a top face and a back face thereof, a first control part provided on the top face of the substrate around at least a part of periphery of the through hole, a second control part provided on the back face of the substrate around at least a part of periphery of the through hole and a protection layer covering the first control part and the second control part, and comprises a control part setting step of providing the first control part on the top face of the substrate and providing the second control part on the back face of the substrate in a position corresponding to the first control part; a step of forming the through hole penetrating the substrate and the control parts by punching processing; and a step of covering the control parts and a wall of the through hole of the substrate with the protection layer.

In this manner, there is no need to make a great effort in positioning the through hole, and hence, there is no need to place a mask at high accuracy.

The method for fabricating a printed substrate according to the thirteenth aspect of the invention is a method for fabricating a printed substrate including a substrate having a through hole penetrating a top face and a back face thereof, a first control part provided on the top face of the substrate around at least a part of periphery of the through hole, a second control part provided on the back face of the substrate around at least a part of periphery of the through hole and a protection layer covering the first control part and the second control part, and comprises a control part setting step of providing the first control part in a ring or arch shape on the top face of the substrate and providing the second control part in a ring or arch shape on the back face of the substrate in a position corresponding to the first control part; a step of forming the through hole in the substrate with the first control part used as a mask; and a step of providing the protection layer on the control parts and a wall of the through hole of the substrate by chemical vapor deposition.

In this manner, since the first control part is used as a mask, there is no need to place a mask at high accuracy.

According to the fourteenth aspect of the invention, the control part setting step includes a step of forming surface layers on the top face and the back face of the substrate; and a step of forming the first control part and the second control part from remaining portions of the surface layers by etching part of the surface layers in the eighth through thirteenth aspects.

In this manner, the control parts are formed on the substrate by a simple and inexpensive method.

According to the fifteenth aspect of the invention, the substrate and the protection layer are made from insulating materials, and the first control part and the second control part are made from conducting materials in the eighth through thirteenth aspects.

In this manner, the control part is obtained as an electrode or a wiring pattern.

The method for fabricating a recording apparatus according to the sixteenth aspect of the invention is a method for fabricating a recording apparatus including developer carrying means for carrying and transferring a charged developer; a rear electrode for generating electrostatic force for absorbing the developer carried by the developer carrying means; and a printed substrate provided between the developer carrying means and the rear electrode and including an insulating substrate having a passing hole for allowing the developer from the developer carrying means to pass therethrough, a first electrode provided on the insulating substrate for controlling passage of the developer through the passing hole in accordance with a control signal and a second electrode provided on the insulating substrate for deflecting or converging the developer passing through the passing hole, and the printed substrate is fabricated by the method for fabricating a printed substrate according to the fifteenth aspect with the first control part formed as the first electrode and the second control part formed as the second electrode in arch-shaped opposing portions opposing each other.

In this manner, a method for fabricating a recording apparatus in which there is no need to place a mask at high accuracy can be obtained.

The method for fabricating a printed substrate according to the seventeenth aspect of the invention is a method for fabricating a printed substrate including an insulating substrate having a through hole, a first control part with a conducting property provided on a top face of the insulating substrate around periphery of the through hole and a second control part with a conducting property provided on a back face of the insulating substrate around periphery of the through hole, and comprises a step of covering an inner wall of the through hole with an insulating film by chemical vapor deposition after forming the through hole penetrating the first control part, the insulating substrate and the second control part.

In this manner, even when the through hole is fine, the inner wall can be definitely covered and the insulating property of the printed substrate can be sufficiently kept.

The method for fabricating a printed substrate according to the eighteenth aspect of the invention is a method for fabricating a printed substrate by using a mask having a through hole penetrating a top face and a back face thereof and having a groove on one face thereof around at least a part of periphery of the through hole, and comprises a holding step of allowing an ink to be held in the groove of the mask; a transferring step of transferring the ink held in the groove onto a base member by placing the mask on a face of the base member; and a space forming step of forming a recess or through hole in the substrate through the mask by using the through hole of the mask as a guide simultaneously with or after the transferring step.

The method for fabricating a printed substrate according to nineteenth aspect of the invention is a method for fabricating a printed substrate by using a mask having a through hole penetrating a top face and a back face thereof and having a print portion capable of printing an ink on one face thereof around at least a part of periphery of the through hole, and comprises a printing step of offsetting the ink on the print portion of the mask; a transferring step of transferring the ink offset on the print portion onto a base member by placing the mask on a face of the base member after the printing step; and a space forming step of forming a recess or through hole in the substrate through the mask by using the through hole of the mask as a guide simultaneously with or after the transferring step.

According to the eighteenth or nineteenth aspect of the invention, the transfer of the ink and the formation of the recess or through hole are carried out by using the same mask. Therefore, the number of times of placing a mask is reduced, resulting in fabricating a printed substrate with ease and at low cost. Also, the influence of a mask alignment error can be suppressed.

The method for fabricating a printed substrate according to the twentieth aspect of the invention is a method for fabricating a printed substrate by using a mask having a through hole penetrating a top face and a back face thereof and having a holding portion capable of holding a curing resin on one face thereof around at least part of periphery of the through hole, and comprises a holding step of allowing the curing resin to be held by the holding portion of the mask; a transferring step of transferring the curing resin held by the holding portion onto a surface layer formed from a material on a base member by placing the mask on a surface of the surface layer; a space forming step of forming a recess or through hole in the base member through the mask by using the through hole of the mask as a guide simultaneously with or after the transferring step; and a step of removing a part of the surface layer by using the transferred curing resin as a guide after the space forming step.

In this manner, the transfer of the curing resin and the formation of the recess or through hole are carried out by using the same mask. Therefore, the number of times of placing a mask is reduced, resulting in fabricating a printed substrate with ease and at low cost. Also, the influence of a mask alignment error can be suppressed.

According to the twenty-first aspect of the invention, the space forming step includes a step of forming a through hole in the base member, and the method further includes a step of placing a transferring member, having a through hole in the same shape as the through hole and having a groove for holding an ink on one face in a position around the through hole, on a back face of the base member with the through hole of the base member overlapping the through hole of the transferring member, and transferring the ink held in the groove onto a position on the-back face of the base member in the eighteenth through twentieth aspects.

According to the twenty-second aspect of the invention, the space forming step includes a step of forming a through hole in the base member, and the method further includes a step of placing a transferring member, having a through hole in the same shape as the through hole and holding an ink on one face in a position around the through hole, on a back face of the base member with the through hole of the base member overlapping the through hole of the transferring member, and transferring the ink onto a position on the back face of the base member in the eighteenth through twentieth aspects.

In this manner, according to the twenty-first or twenty-second aspect of the invention, the ink is transferred not only onto the top face but also onto the back face of the base member.

According to the twenty-third aspect of the invention, the space forming step includes a step of forming a through hole in the base member, and the method further includes the steps of forming a surface layer of a material on a back face of the base member; placing a transferring member, having a through hole in the same shape as the through hole and having a curing resin on one face thereof in a position around the through hole, on the surface layer with the through hole of the base member overlapping the through hole of the transferring member and transferring the curing resin onto the surface layer; and removing a part of the surface layer by using the transferred curing resin as a guide in the eighteenth through twentieth aspects.

In this manner, the curing resin is transferred not only onto the top face but also onto the back face of the base member.

According to the twenty-fourth aspect of the invention, the base member is made from an insulating substrate and the ink is made from a conducting material, and the ink transferred onto the insulating substrate forms an electrode in the eighteenth through twentieth aspects.

According to the twenty-fifth aspect of the invention, the base member is made from an insulating substrate and the surface layer is made from a conducting material, and a portion of the surface layer remaining on the insulating substrate forms an electrode in the twentieth aspect.

In this manner, according to the twenty-fourth or twenty-fifth aspect of the invention, a printed substrate equipped with an electrode can be obtained.

According to the twenty-sixth aspect of the invention, the method further comprises a step of forming an insulating layer for covering the electrode at least on the top face and the back face of the insulating substrate in the twenty-fourth or twenty-fifth aspect.

In this manner, the insulating layer is formed on at least both faces of the printed substrate, so that short-circuit between electrodes can be definitely prevented and that adhesion of contaminant and the like can be prevented.

The method for fabricating a recording apparatus according to the twenty-seventh aspect of the invention is a method for fabricating a recording apparatus including developer carrying means for carrying and transferring a charged developer; a rear electrode for generating electrostatic force for absorbing the developer carried by the developer carrying means; and a printed substrate provided between the developer carrying means and the rear electrode and including an insulating substrate having a passing hole for allowing the developer from the developer carrying means to pass therethrough, a first electrode for controlling passage of the developer through the passing hole in accordance with a control signal and a second electrode for deflecting or converging the developer passing through the passing hole, and the printed substrate is fabricated by the method for fabricating a printed substrate according to the twenty sixth aspect with an electrode formed on the top face of the insulating substrate formed as the first electrode and an electrode formed on the back face of the insulating substrate formed as the second electrode.

In this manner, a method for fabricating a recording apparatus utilizing the twenty-sixth aspect of the invention is obtained.

The mask for use in fabrication of a printed substrate according to the twenty-eighth aspect of the invention comprises a through hole penetrating a top face and a back face thereof; and a groove capable of holding an ink formed on one face thereof around at least a part of periphery of the through hole.

In this manner, the mask for use in fabrication of a printed substrate particularly suitable to the eighteenth aspect of the invention is obtained.

The mask for use in fabrication of a printed substrate according to the twenty-ninth aspect of the invention comprises a through hole penetrating a top face and a back face thereof; and a holding portion capable of holding an ink formed on one face thereof around at least a part of periphery of the through hole.

In this manner, the mask for use in fabrication of a printed substrate particularly suitable to the nineteenth aspect of the invention is obtained.

The mask for use in fabrication of a printed substrate according to the thirtieth aspect of the invention comprises a through hole penetrating a top face and a back face thereof; and a holding portion capable of holding a curing resin on one face thereof around at least a part of periphery of the through hole.

In this manner, the mask for use in fabrication of a printed substrate particularly suitable to the twentieth aspect of the invention is obtained.

As described so far, according to the invention, there is no need, in forming a through hole in a substrate, to carry out highly accurate processing as in the conventional technique. Therefore, a printed substrate can be fabricated with ease and at low cost. Accordingly, a printing apparatus including the printed substrate can be fabricated at low cost and with ease.

Furthermore, according to the invention, the formation of a through hole or recess and the transfer of an ink or curing resin are carried out by using the same mask. Therefore, the number of times of placing a mask is reduced, so as to reduce a mask alignment error. Accordingly, the printed substrate can be fabricated more highly accurately, with ease and at low cost. As a result, a recording apparatus including the printed substrate can be fabricated with ease and at low cost.

### Brief Description of Drawings

FIG. **1** is a schematic diagram for showing the entire structure of a recording apparatus.
FIG. **2(a)** is a plane view of a part of a printed substrate and FIG. **2(b)** is a cross-sectional view taken on line X-X of FIG. **2(a).**
FIG. **3** is a rear view of a part of the printed substrate.
FIGS. **4(a)** through **4(d)** are diagrams for showing part of procedures in a method for fabricating the printed substrate.
FIGS. **5(a)** and **5(b)** are diagrams for showing part of the procedures in the method for fabricating the printed substrate.
FIGS. **6(a)** through **6(d)** are diagrams for showing part of the procedures in the method for fabricating the printed substrate.
FIGS. **7(a)** and **7(b)** are respectively a top view and a back view of the printed substrate corresponding to FIG. **6(a).**
FIGS. **8(a)** and **8(b)** are respectively a top view and a back view of the printed substrate corresponding to FIG. **6(b).**
FIGS. **9(a)** and **9(b)** are respectively a top view and a back view of the printed substrate corresponding to FIG. **6(c).**
FIGS. **10(a)** through **10(c)** are diagrams for showing part of procedures in another method for fabricating a printed substrate.
FIG. **11** is a diagram for showing the structure of an apparatus for forming an insulating protection film.
FIGS. **12(a)** through **12(d)** are procedures for showing part of procedures in another method for fabricating a printed substrate.
FIG. **13(a)** is a plane view of a part of a mask and FIG.
**13(b)** is a cross-sectional view taken on line Y-Y of FIG. **13(a).**
FIG. **14(a)** is a plane view of a part of a transferring member and FIG. **14(b)** is a cross-sectional view taken on line Z-Z of FIG. **14(a).**
FIGS. **15(a)** through **15(c)** are diagrams for showing part of procedures in another method for fabricating a printed substrate.
FIGS. **16(a)** through **16(c)** are diagrams for showing part of procedures in another method for fabricating a printed substrate.
FIGS. **17(a)** through **17(e)** are diagrams for showing part of procedures in another method for fabricating a printed substrate.

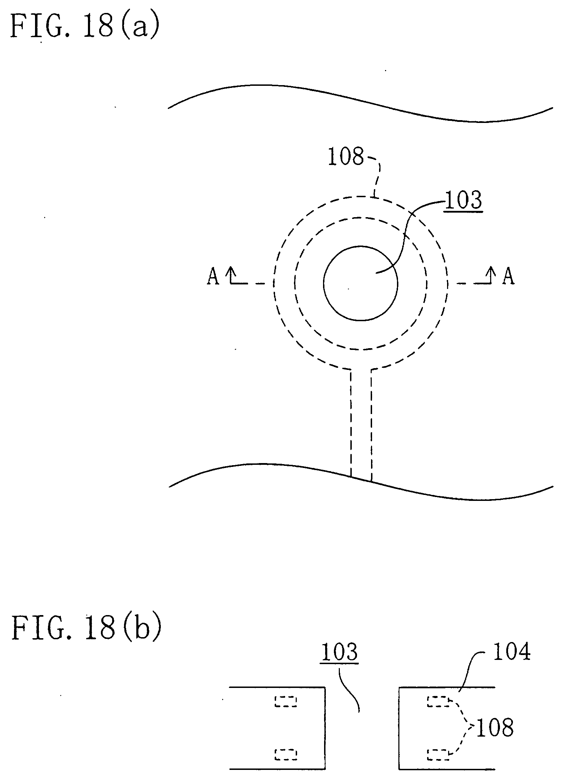

FIG. **18(a)** is a top view of a conventional printed substrate and FIG. **18(b)** is a cross-sectional view taken on line A-A of FIG. **18(a).**
FIGS. **19(a)** through **19(d)** are diagrams for showing part of procedures in a method for fabricating the conventional printed substrate.
FIGS. **20(a)** through **20(d)** are diagrams for showing part of the procedures in the method for fabricating the conventional printed substrate.

### Best Mode for Carrying Out the Invention

Preferred embodiments of the invention will now be described with reference to the accompanying drawings.

### <EMBODIMENT 1>

First, a printed substrate **10** (controlling member) fabricated by a fabrication method of this embodiment and a recording apparatus **1** including the same will be described.

### - Structure of recording apparatus 1 -

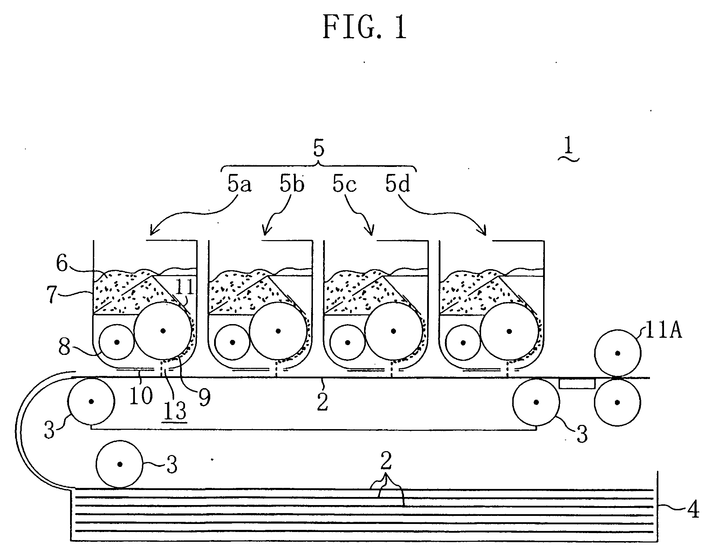

As shown in FIG. **1,** the recording apparatus **1** is the so-called toner jet (trademark) printer. The recording apparatus **1** includes a paper cassette **4** storing recording paper **2** used as a recording medium, transferring rollers **3** for transferring the recording paper **2,** and first through fourth toner supply members **5a** through **5d** for respectively allowing toners of four colors, yellow (Y), magenta (M), cyan (C) and black (B), to adhere onto the recording paper **2.**

In each toner supply member **5,** a toner **6** stored in a toner case **7** is charged by a driving roller **8** and supplied to a carrying roller **9** (corresponding to "developer carrying means"). The toner **6** carried by the carrying roller **9** is further charged and reduced in the thickness by a toner thickness controlling blade **11** and transferred toward the printed substrate **10.** Then, the toner **6** carried by the carrying roller **9** is supplied with electrostatic force for controlling its passage through a passing hole **13** by an electrode of the printed substrate **10.** Specifically, the toner **6** is supplied with force for passing through the passing hole **13** in recording and with force for inhibiting the passage through the passing hole **13** in not recording on the basis of a predetermined control signal. The toner **6** having passed through the passing hole **13** is absorbed by a rear electrode not shown provided on the back surface of the recording paper **2.** As a result, the toner **6** passes through the passing hole **13** to adhere onto the recording paper **2.** The toner **6** adhered onto the recording paper **2** is heated while it is passing through heat rollers **11A** so as to be fixed on the recording paper **2.**

### - Structure of printed substrate 10 -

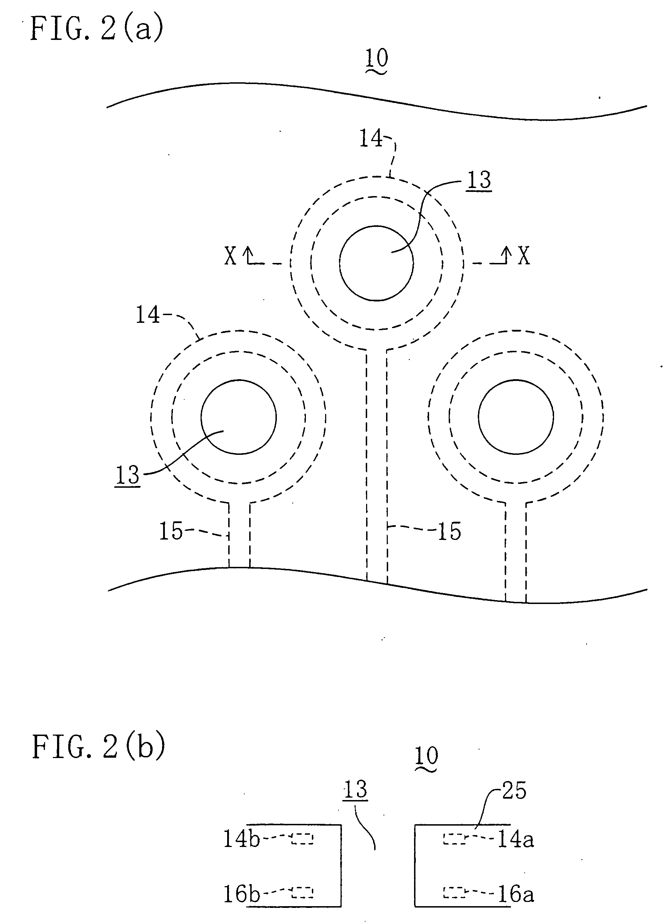

Next, the structure of the printed substrate **10** serving as the controlling member for controlling the passage of the toner **6** will be described. As shown in FIGS. **2(a)** and **2(b),** the printed substrate **10** includes an insulating substrate **25** having a plurality of passing holes **13** and formed from polyimide or a material of the polyimide family, and control electrodes **14 (14a** and **14b)** (corresponding to a "first control part") and deflecting electrodes **16 (16a** and **16b)** (corresponding to a "second control part") provided in the insulating substrate **25.** The control electrode **14** and the deflecting electrode **16** together surround the passing hole **13.** The control electrode **14** is provided on the top face of the insulating substrate **25** and the deflecting electrode **16** is provided on the back face of the insulating substrate **25.** The thickness of the insulating substrate **25** is preferably approximately 40 *µ*m through 60 *µ*m, and is set to 50 *µ*m in this embodiment. The thickness of each of the control electrode **14** and the deflecting electrode **16** is preferably approximately 1 *µ*m through 20 *µ*m, and is set to 9 *µ*m in this embodiment.

As shown in FIG. **2(a)** in detail, each control electrode **14** is formed in a ring shape slightly larger than the passing hole **13** so as to surround the passing hole **13.** In this embodiment, the diameter of the passing hole **13** is set to 100 *µ*m, the inner diameter of the ring of the control electrode **14** is set to 110 *µ*m and the outer diameter of the ring of the control electrode **14** is set to 160 *µ*m. Each control electrode **14** is provided with a wiring part **15** extending along one direction, so that each control electrode **14** can be connected to a driving circuit not shown through the wiring part **15.** The control electrode **14** and the wiring part **15** are formed from a conducting material such as copper.

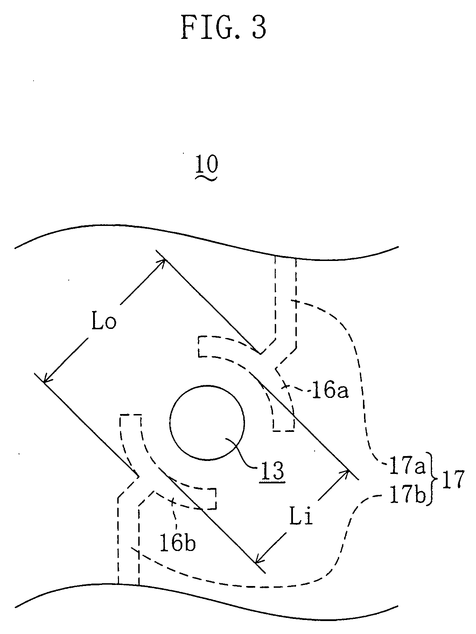

As shown in FIG. **3,** the deflecting electrode **16** includes a first electrode **16a** and a second electrode **16b** opposing each other with the passing hole **13** sandwiched therebetween. Each of the first electrode **16a** and the second electrode **16b** (corresponding to "opposing portions") is formed in an arch shape concentrical with the passing hole **13** so as to surround a part of the circumference of the passing hole **13.** The inner edge of each of the first electrode **16a** and the second electrode **16b** is away from the outer edge of the passing hole **13** by 5 *µ*m, and a distance Li between the inner edges of the electrodes **16a** and **16b** is set to 110 *µ*m. Specifically, the inner edge distance **Li** is equal to the inner diameter of the control electrode **14.** Also, a distance **Lo** between the outer edges of the electrodes **16a** and **16b** is set to 160 *µ*m. The electrodes **16a** and **16b** are respectively provided with linear wiring parts **17a** and **17b** extending along reverse directions. The electrodes **16a** and **16b** are connected to a driving circuit not shown through the wiring parts **17a** and **17b** (wiring part **17).** The deflecting electrode **16** and the wiring part **17** are formed from a conducting material such as copper similarly to the control electrode **14** and the wiring part **15.**

### - Method for fabricating printed substrate 10 -

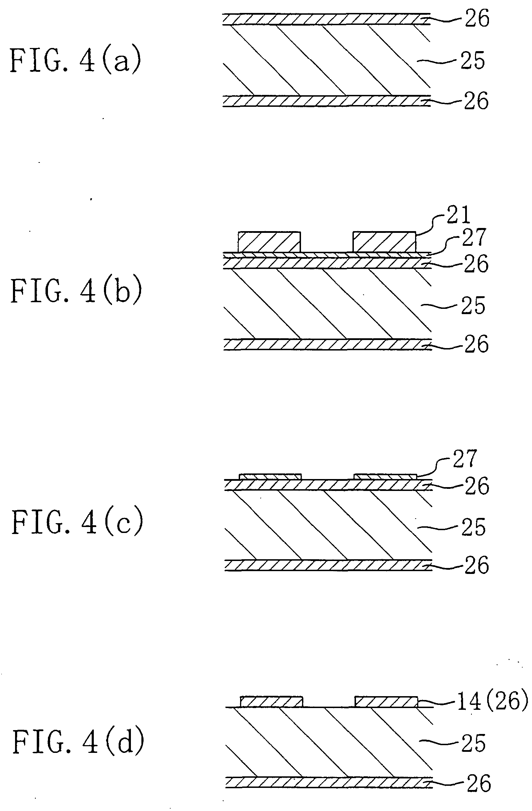

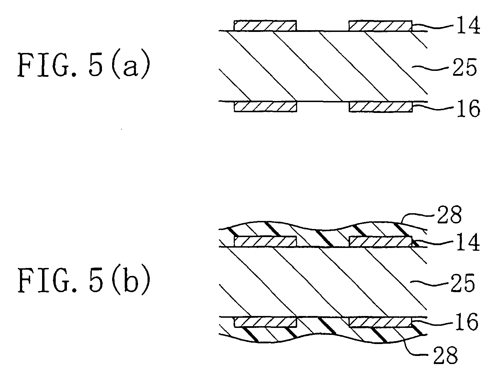

Next, a method for fabricating the printed substrate **10** of this embodiment will be described. First, as shown in FIG. **4(a),** conducting layers **26** of copper are formed on both faces of an insulating substrate **25** of polyimide or a material of the polyimide family. Next, as shown in FIG. **4(b),** a resist **27** is applied to the conducting layer **26** formed on one face (the upper face in FIG. **4)** of the insulating substrate **25,** and a mask **21** is placed thereon. Thereafter, as shown in FIG. **4(c),** exposure is carried out through the mask **21,** so as to pattern the resist **27.** Next, as shown in FIG. **4(d),** with the resist **27** used as a mask, the conducting layer **26** is selectively removed by using an etchant of the permanganic acid family. In other words, the conducting layer **26** is patterned. Thereafter, the conducting layer **26** formed on the other face (the lower face in the drawing) of the insulating substrate **25** is patterned in the same manner as described above. As a result, as shown in FIG. **5(a),** a control electrode **14** is formed from a remaining portion of the conducting layer **26** on the top face (upper face in the drawing) of the insulating substrate **25,** and a deflecting electrode **16** is formed from a remaining portion of the conducting layer **26** on the back face (lower face in the drawing) of the insulating substrate **25** (controlling part setting step).

Next, as shown in FIG. **5(b),** an insulating protection layer **28** is formed on the both faces of the insulating substrate **25** so as to cover the control electrode **14** and the deflecting electrode **16.**

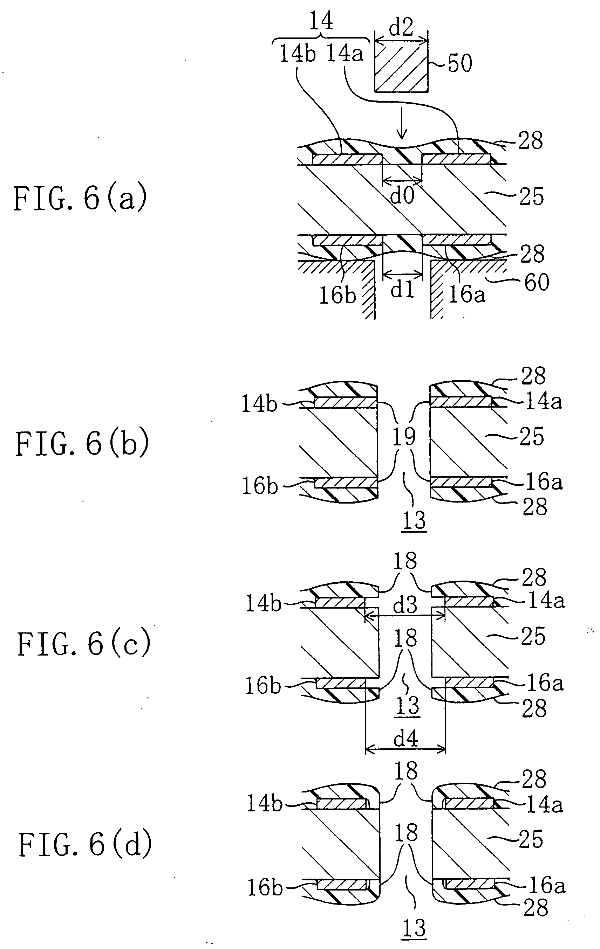

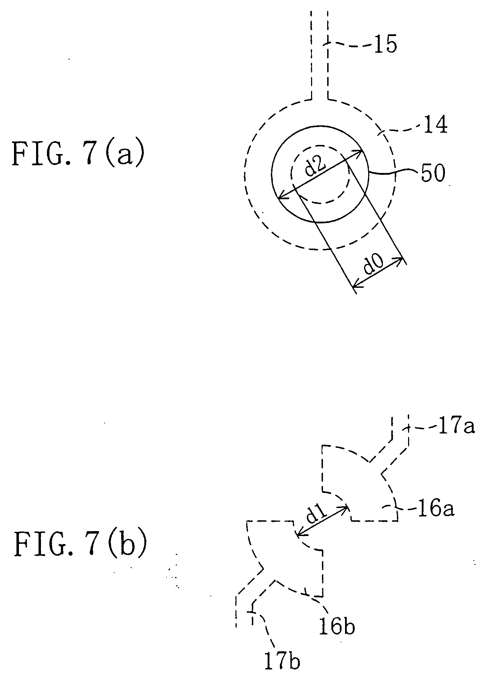

Then, as shown in FIG. **6(a),** a punching process is carried out so as to punch the control electrode **14,** the insulating substrate **25** and the deflecting electrode **16,** thereby forming a passing hole **13.** Specifically, a die **60** having a hole with a clearance of approximately 0.5 *µ*m through 20 *µ* m from a punch **50** is placed on the back face of the insulating substrate **25,** and the punch **50** (as shown in FIG. **7(a))** having an outer diameter **d2** larger than the inner diameter **d0** of the control electrode **14** and the inner diameter **d1** of the deflecting electrode **16** is pressed against the insulating protection film **28** formed on the top face of the insulating substrate **25** from above, so as to form the passing hole **13** with the diameter **d2** larger than the inner diameter **d0** of the control electrode **14.** In this embodiment, since the top face and the back face of the substrate **25** are simultaneously processed in this manner, there is no need to adjust the positional relationship between the passing hole formed in the control electrode **14** and the passing hole formed in the deflecting electrode **16,** and the concentricity between these holes can be highly kept. Accordingly, there is no need to place a mask at high accuracy. The inner diameter **d0** of the control electrode **14** and the inner diameter **d1** of the deflecting electrode **16** may be equal to each other or different from each other.

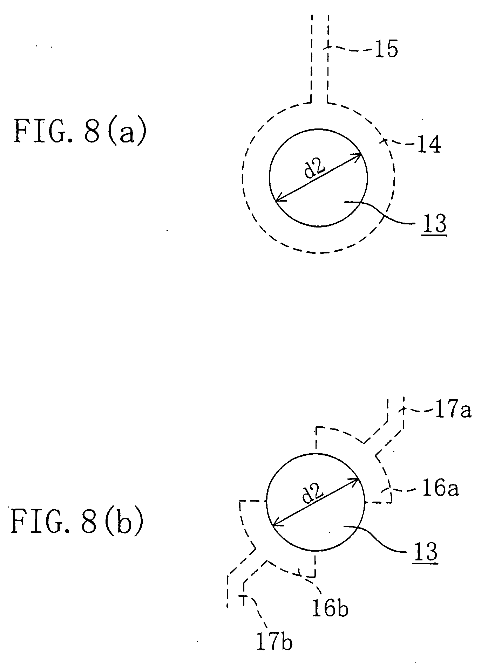

Through this punching process, part of the control electrode **14** and the deflecting electrode **16** are exposed on the inner wall of the passing hole **13** as shown in FIGS. **6(b)** and **8.** Furthermore, since the diameter **d2** of the punch **50** is larger than the inner diameter **d0** of the control electrode **14** and the inner diameter **d1** of the deflecting electrode **16,** not only the insulating substrate **25** and the insulating protection film **28** but also part of the control electrode **14** and the deflecting electrode **16** may be removed.

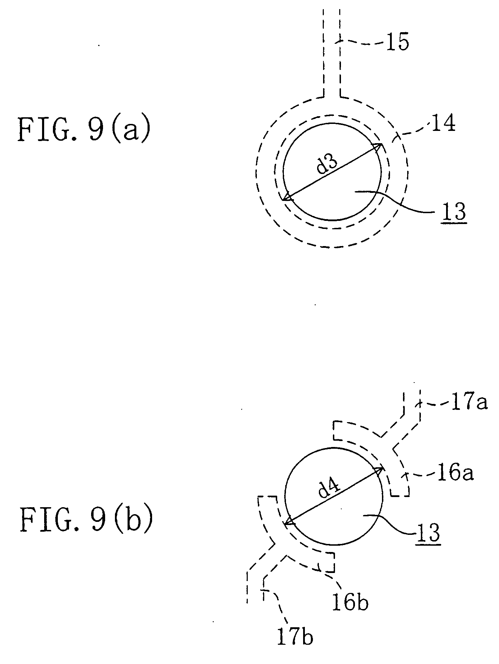

Next, as shown in FIGS. **6(c)** and **9,** the exposed portions **19** of the control electrode **14** and the deflecting electrode **16** are selectively etched by using an etchant of the permanganic acid family.

Thereafter, as shown in FIG. **6(d),** opening edges **18** around the through hole of the insulating protection layer **28** are bent toward and adhered onto the insulating substrate **25** so as to cover the control electrode **14** and the deflecting electrode **16** (covering step). Specifically, the control electrode **14** and the deflecting electrode **16** are buried between the insulating protection layer **28** and the insulating substrate **25.**

As described above, according to this embodiment, there is no need to place a mask at high accuracy in forming the passing hole **13,** and hence, the printed substrate **10** can be fabricated at low cost and with ease. Accordingly, the recording apparatus 1 can be fabricated at low cost and with ease.

In this embodiment, after etching the control electrode **14** and the deflecting electrode **16,** the exposed portions may be covered with a protection layer of another material. In this embodiment, however, the control electrode **14** and the deflecting electrode **16** are covered by bending the opening edges **18** of the protection layer **28,** and hence, there is no need to cover the exposed portions of the control electrode **14** and the deflecting electrode **16** with another material, which can further reduce the fabrication cost.

### - Modifications -

In the aforementioned embodiment, the conducting layers **26** are patterned so as to allow the ring-shaped control electrode **14** and the semi-ring-shaped (similar to 1/4 of a ring) deflecting electrode **16** to remain in the control part setting step. It goes without saying that the control electrode **14** and the deflecting electrode **16** obtained before the punching process may not be in the ring or semi-ring shape. The control electrode and the deflecting electrode may be patterned to respectively have circular and arch shapes (with no hole at the center) and then formed into the ring or semi-ring shape by the punching process.

Furthermore, the inner portions of the control electrode **14** and the deflecting electrode **16** may be used as a target in positioning the punch **50** or the conducting layers in the inner portions may remain without being removed.

### <EMBODIMENT 2>

In a fabrication method according to Embodiment 2, a control electrode **14** and a deflecting electrode **16** are respectively formed on the top and back faces of an insulating substrate **25** in the same manner as in Embodiment 1 (control part setting step).

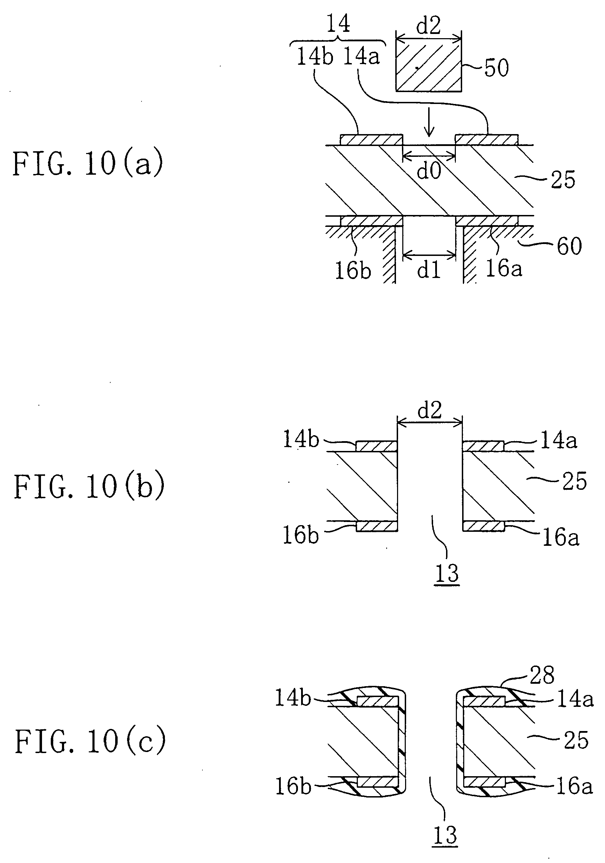

Thereafter, as shown in FIG. **10(a),** a punch **50** is pressed from above the control electrode **14** and the top face of the insulating substrate **25,** so as to form a passing hole **13.** The outer diameter of the punch **50** is set to a diameter **d2** larger than the inner diameter **d0** of the control electrode **14** and the inner diameter **d1** of the deflecting electrode **16** so that the diameter **d2** of the passing hole **13** can be larger than the inner diameter **d0** of the control electrode **14.** Accordingly, also in this embodiment, the passing hole **13** is formed simultaneously in the substrate **25,** the control electrode **14** and the deflecting electrode **16,** and hence, there is no need to place a mask at high accuracy.

Furthermore, as shown in FIG. **10(b),** also in this embodiment, since the diameter **d2** of the punch **50** is larger than the inner diameter **d0** of the control electrode **14** and the inner diameter **d1** of the deflecting electrode **16,** part of the control electrode **14** and the deflecting electrode **16** may be removed.

Thereafter, as shown in FIG. **10(c),** an insulating protection layer **28** of polyimide, polyparaxylene, paraxylene fluoride or the like is formed on the insulating substrate **25** so as to cover the control electrode **14,** the deflecting electrode **16** and the wall of the passing hole **13.** Herein, a method for forming the insulating protection layer **28** of polyparaxylene by chemical vapor deposition (CVD) will be described.

### - Formation of insulating protection layer by chemical vapor deposition -

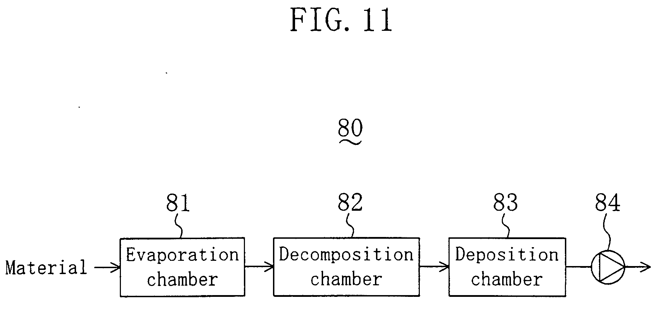

As shown in FIG. **11,** an apparatus **80** for forming the insulating protection layer includes an evaporation chamber **81** for evaporating a material, a decomposition chamber **82** for thermally decomposing the evaporated material, a deposition chamber for depositing the thermally decomposed material on the insulating substrate **25** provided with the control electrode **14** and the deflecting electrode **16,** and a vacuum pump **84** for reducing the pressure within the deposition chamber **83.**

For the formation of the insulating protection layer, the insulating substrate **25** provided with the control electrode **14** and the deflecting electrode **16** is first placed in the deposition chamber **83** and a polyparaxylene material (dimer) is supplied to the evaporation chamber **81.** The polyparaxylene material is heated to a temperature lower than approximately 170°C in the evaporation chamber **81** to be evaporated. The evaporated polyparaxylene material is transferred to the decomposition chamber **82** and heated at a temperature of approximately 690°C so as to be thermally decomposed as represented by formula (1) below. As a result, the polyparaxylene is changed into a radical monomer.

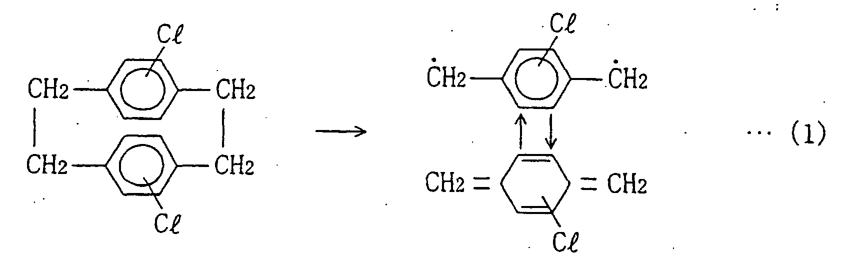

The polyparaxylene having been thus changed into a monomer is transferred to the deposition chamber **83** kept at room temperature and reduced pressure. When the polyparaxylene changed into the monomer is brought into contact with the surfaces of the electrodes **14** and **16** and the insulating substrate **25,** the monomer is polymerized on the interface as represented by formula (2) below. As a result, a high molecular polyparaxylene film is formed as the insulating protection film on the surfaces of the electrodes **14** and **16** and the insulating substrate **25.**

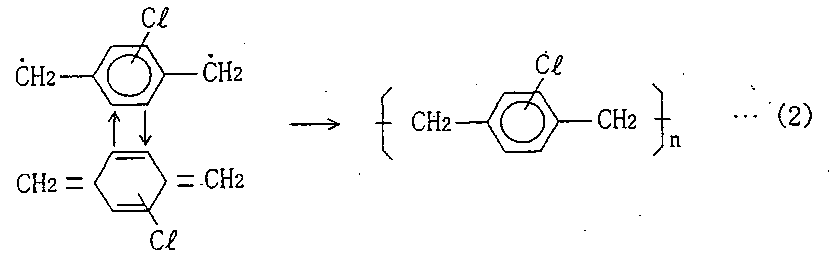

As described so far, also in Embodiment 2, there is no need to place a mask at high accuracy in forming the passing hole **13,** and hence, the printed substrate **10** can be fabricated at low cost and with ease. Accordingly, the recording apparatus **1** can be fabricated at low cost and with ease.

Furthermore, since the insulating protection layer is formed by the chemical vapor deposition, a good protection film can be formed not only on the front and back faces of the substrate **25** but also on the inner wall of the small passing hole **13.**

Although the inner portion of the control electrode **14** and the inner portion of the deflecting electrode **16** can be used as a target for positioning the punch **50,** the conducting layer in the inner portions may remain without being removed.

### <EMBODIMENT 3>

In Embodiment 3, the holing process of Embodiment 2 is carried out by laser processing.

Specifically, a control electrode **14** and a deflecting electrode **16** are respectively formed on the front and back faces of an insulating substrate **25** in the same manner as in Embodiment 1 (control part setting step).

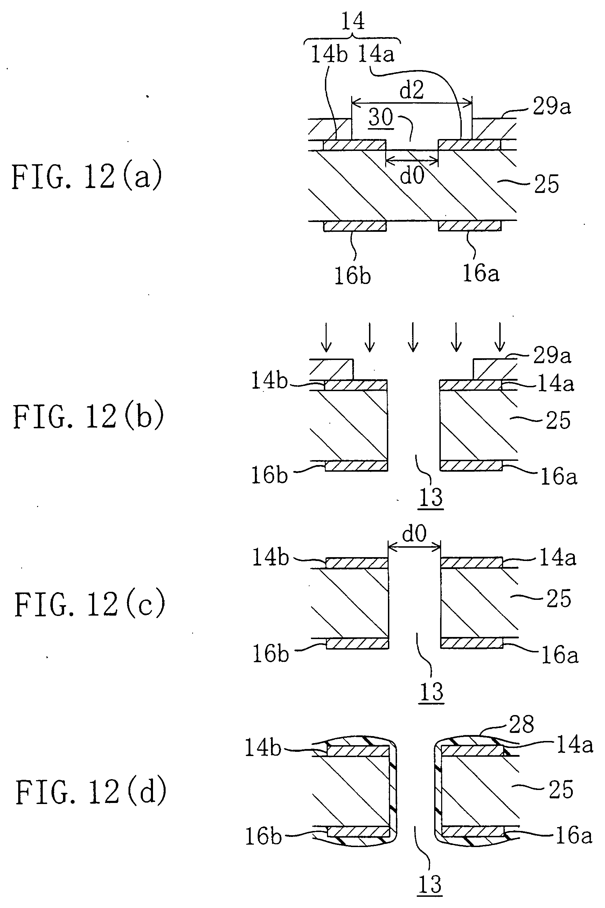

Thereafter, as shown in FIG. **12(a),** a mask **29a** is placed on the top face of the insulating substrate **25** and the control electrode **14** so as to cover a portion which is not to be processed by the laser processing described below, namely, an outer portion of the control electrode **14.** Specifically, the mask **29a** is placed so that the diameter **d2** of a through hole **30** of the mask **29a** can be larger than the inner diameter **d0** of the control electrode **14** and that the insulating substrate **25** within the inner portion of the control electrode **14** can be exposed.

Next, as shown in FIG. **12(b),** the holing process is carried out through irradiation with a laser beam by using the control electrode **14** and the mask **29a** as guides. As a result, as shown in FIG. **12(c),** a through hole **13** having a diameter corresponding to the predetermined dimension **d0** is formed in the inner portion of the control electrode **14.**

Thereafter, in the same manner as in Embodiment 2, an insulating protection layer **28** of polyimide, polyparaxylene, paraxylene fluoride or the like is formed on the insulating substrate **25** so as to cover the control electrode **14,** the deflecting electrode **16** and the wall of the through hole **13** as shown in FIG. **12(d).**

As described above, according to Embodiment **3,** there is no need to attain high accuracy as in the conventional technique in placing the mask for forming the passing hole **13,** and hence, the printed substrate **10** can be fabricated at low cost and with ease. Accordingly, the recording apparatus **1** can be fabricated at low cost and with ease.

### - Modifications -

Although the laser processing employed in the above-described embodiment is a process utilizing the mask **29a,** the laser processing for forming the passing hole **13** may be laser processing not utilizing a mask.

The irradiation of laser may be carried out with the irradiation position fixed so as to form the passing hole **13** in the irradiation position or the irradiation position may be moved along the circumference of the passing hole **13** so as to cut off the substrate **25** and the like with the laser.

The insulating substrate **25** is not limited to a single-layer substrate formed from a single material but may be a multi-layer substrate in which a plurality of layers of a plurality of materials are stacked.

Furthermore, the fabrication method may be as follows: A through hole is formed in a multi-layer substrate including at least three layers of an insulating layer, a conducting layer and another insulating layer in this order, the conducting layer is etched from its exposed portion within the through hole in a radial direction of the through hole, and then, the insulating layers are brought into contact with to each other so that the conducting layer covered with the insulating layers can be used as an electrode.

Moreover, the control electrode **14** and the deflecting electrode **16** may be formed not in different steps but formed through simultaneous exposure or simultaneous etching.

### <EMBODIMENT 4>

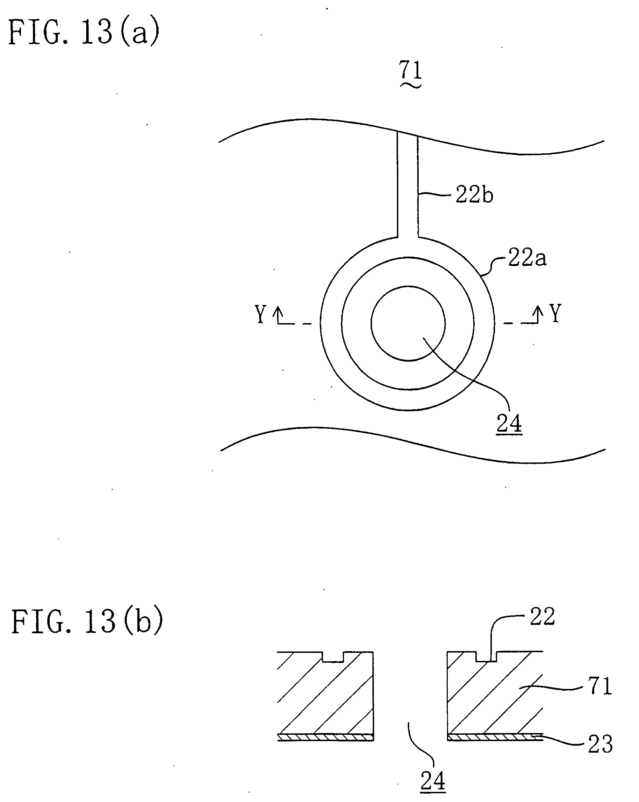

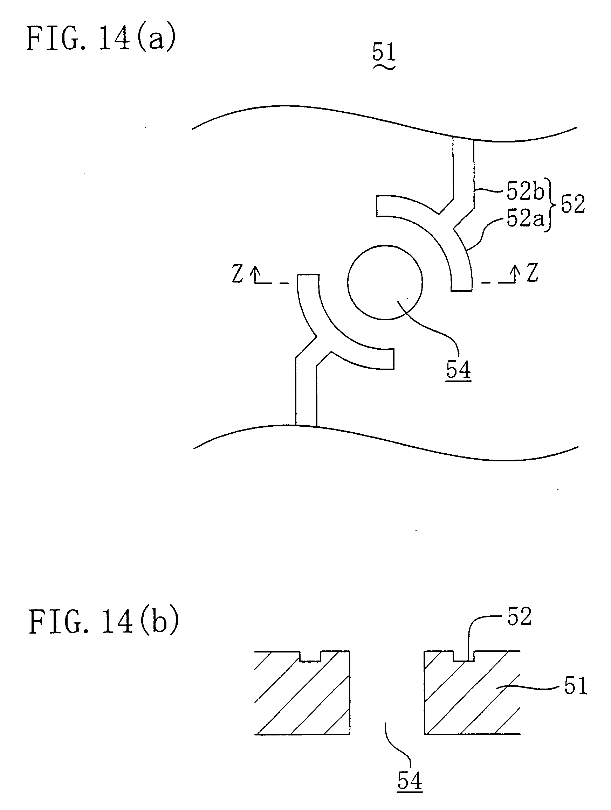

A fabrication method according to Embodiment 4 is a fabrication method utilizing a printing plate as a mask for fabrication. Specifically, the holing process of an insulating substrate **25** and formation of a control electrode **14** and a wiring part **15** are carried out by using a mask **71** shown in FIG. **13,** and formation of a deflecting electrode **16** and a wiring part **17** is carried out by using a transferring member **51** shown in FIG. **14.**

As shown in FIGS. **13(a)** and **13(b),** a plurality of through holes **24** respectively corresponding to passing holes **13** of the insulating substrate **25** are formed in the mask **71.** On one face of the mask **71,** a groove **22** for holding a conducting ink is formed in a position corresponding to the control electrode **14** and the wiring part **15** (see FIG. **2).** The groove **22** includes a ring portion **22a** formed in a ring shape surrounding the circumference of the through hole **24** in a position away from the opening edge of the through hole **24** by a predetermined distance in the radial direction and a linear portion **22b** linearly extending from the ring portion **22a** along one direction. The cross-section of the groove **22** may be a round recess in an arch shape, etc. or a rectangular shape. Alternatively, it may be in a reverse triangle shape or another polygonal shape. The depth and the width of the groove **22** can be optionally set in accordance with the control electrode **14** and the wiring part **15** to be formed on the insulating substrate **25.**

on the other face of the mask **71,** a protection layer **23** for shading a laser beam is formed, whereas the protection layer **23** is not always necessary and can be appropriately omitted depending upon the type of the holing process employed for forming the passing hole **13** of the insulating substrate **25.**

Next, the transferring member **51** used in forming the deflecting electrode **16** and the wiring part **17** will be described. As shown in FIGS. **14(a)** and **14(b),** the transferring member **51** is a plate having a through hole **54** corresponding to the passing hole **13** of the insulating substrate **25** and a groove **52** corresponding to the deflecting electrode **16** and the wiring part **17.** The through hole **54** is formed in order to ease the alignment between the transferring member **51** and the insulating substrate **25** by overlapping it on the through hole **13** of the insulating substrate **25.** Accordingly, when the transferring member **51** is aligned against the insulating substrate **25** by another method, the through hole **54** is not particularly necessary.

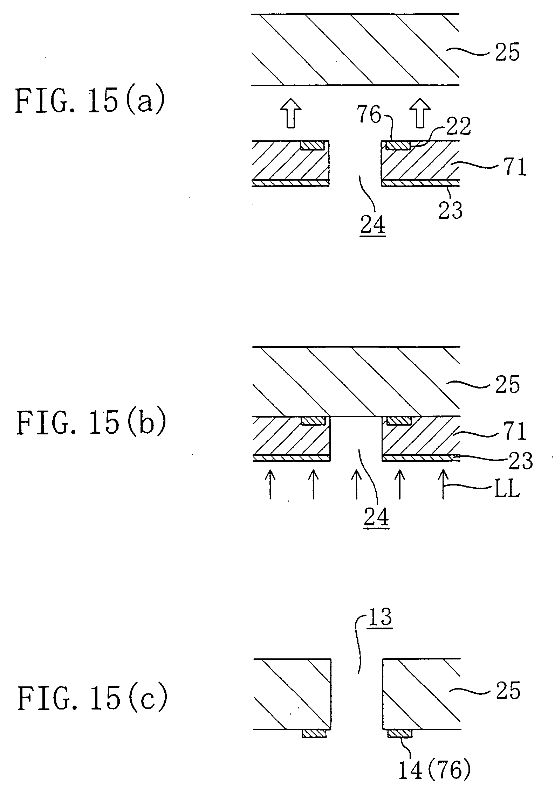

Next, the method for fabricating a printed substrate **10** by using the mask **71** and the transferring member **51** will be described with reference to FIGS. **15(a)** through **15(d).** First, as shown in FIG. **15(a),** the mask **71** holding a conducting ink **76** in the groove **22** is brought into contact with the face of an insulating substrate **25** of polyimide or a material of the polyimide family. Thus, the conducting ink **76** is transferred onto a predetermined position on the face of the insulating substrate **25,** so that a control electrode **14** and a wiring part **15** can be formed with the transferred conducting ink **76.**

Next, as shown in FIG. **15(b),** a laser beam **LL** is irradiated through the mask **71.** Thus, a passing hole **13** is formed in the insulating substrate **25** in a position corresponding to the through hole **24** of the mask **71.** In other words, the holing process is carried out on the insulating substrate **25** by using laser with the through hole **24** used as a guide. The holing process is not limited to the laser processing but may be carried out by pressing or the like.

Then, as shown in FIG. **15(c),** the mask **71** is removed from the insulating substrate **25.**

Thereafter, a deflecting electrode **16** and a wiring part **17** are formed on the back face of the mask **71** by using the transferring member **51** in the same manner as described above. Specifically, with a conducting ink held in the groove **52** of the transferring member **51,** the transferring member **51** is aligned in a predetermined position and brought into contact with the back face of the insulating substrate **25.** Thus, the conducting ink is transferred onto a predetermined position on the back face of the insulating substrate **25,** so that the deflecting electrode **16** and the wiring part **17** can be formed with the conducting ink.

Thereafter, an insulating protection film of polyparaxylene, paraxylene fluoride or the like may be formed on the insulating substrate **25,** the control electrode **14,** the deflecting electrode **16** and the wiring parts **15** and **17.** Also, the insulating protection film may be formed so as to cover the inner wall of the passing hole **13.**

### <EMBODIMENT 5>

A method for fabricating a printed substrate **10** according to Embodiment 5 is a method utilizing a mask **31** having a through hole **24** and having a conducting ink **77** offset on one face thereof. Specifically, in the mask **31** of this embodiment, the conducting ink **77** is held in a predetermined position corresponding to a control electrode **14** and a wiring part **15** with no conducting ink **77** held in other positions.

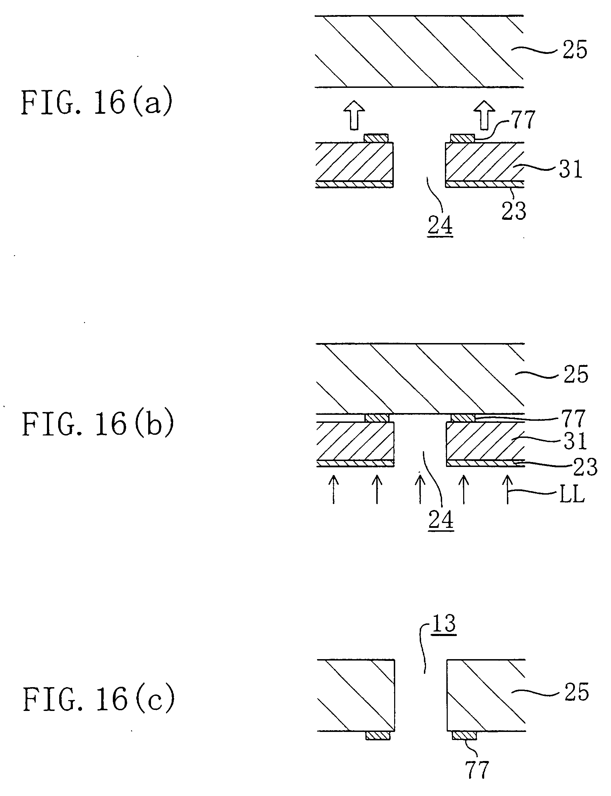

In the fabrication method of this embodiment, the conducting ink **77** is first offset in the predetermined position on the mask **31.** Then, as shown in FIG. **16(a),** the mask **31** is brought into contact with an insulating substrate **25** of polyimide or a material of the polyimide family. Thus, the conducting ink **77** is transferred onto a predetermined position on the face of the insulating substrate **25,** so that the control electrode **14** and the wiring part **15** can be formed with the conducting ink **77.**

Next, as shown in FIG. **16(b),** a laser beam **LL** is irradiated through the mask **31,** thereby conducting the holing process on the insulating substrate **25** with the through hole **24** of the mask **31** used as a guide. Thus, a passing hole **13** is formed in the insulating substrate **25** in a position corresponding to the through hole **24** of the mask **31.** The holing process may be carried out pressing or the like.

Then, as shown in FIG. **16(c),** the mask **31** is removed from the insulating substrate **25.**

Thereafter, a transferring member (not shown) holding a conducting ink in a position corresponding to a deflecting electrode **16** and a wiring part **17** is brought into contact with the back face of the insulating substrate **25,** so as to transfer the conducting ink. Thus, the deflecting electrode **16** and the wiring part **17** are formed on the back face of the insulating substrate **25.**

Also in Embodiment 5, the control electrode **14,** the deflecting electrode **16,** the wiring parts **15** and **17** or the inner wall of the passing hole **13** may be covered with an insulating protection film of polyparaxylene, parylene or the like.

### <EMBODIMENT 6>

A fabrication method of Embodiment 6 is a method utilizing a mask **41** having a through hole used for forming a passing hole **13** and capable of applying a curing resin on one face thereof in a predetermined position around the through hole. In other words, the fabrication method utilizes the mask **41** capable of holding a resist **78** of a curing resin formed in a pattern corresponding to a control electrode **14** and a wiring part **15.**

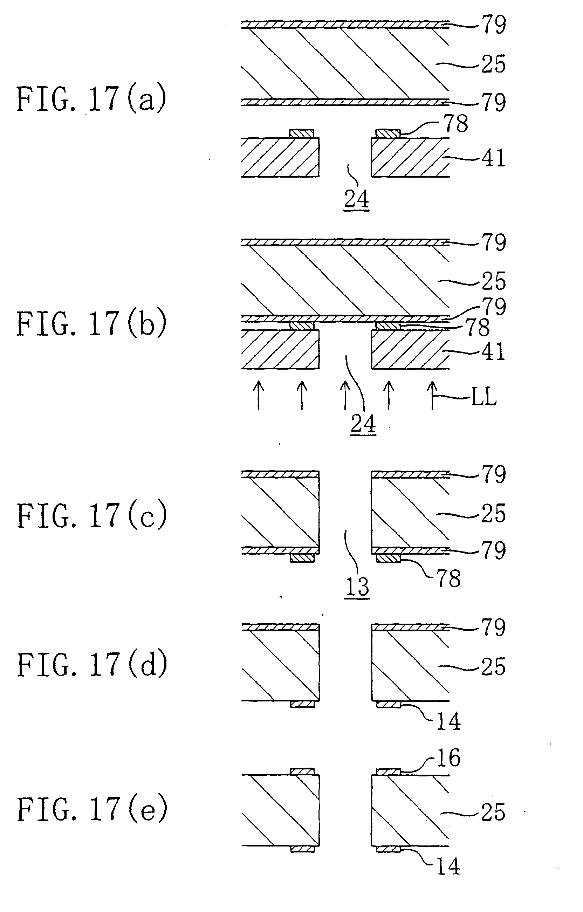

In this fabrication method, a conducting layer 79 ("surface layer") of a conducting material such as copper is first formed on both faces of an insulating substrate 25 of polyimide or a material of the polyimide family as shown in FIG. **17(a).** The insulating substrate **25** and the conducting layer **79** respectively have a thickness of, for example, approximately 50 *µ*m and 18 *µ*m. Also, on one face of the mask **41,** the resist **78** of a thermosetting resin is formed in a pattern corresponding to the control electrode **14** and the wiring part **15.**

Next, as shown in FIG. **17(b),** the mask **41** is brought into contact with the conducting layer **79** formed on the top face of the insulating substrate **25,** so as to transfer the resist **78** onto the conducting layer **79.** Furthermore, a laser beam **LL** is irradiated through the mask **41,** so as to carry out the holing process on the insulating substrate **25** and the conducting layer **79.** Thus, a passing hole **13** is formed in the insulating substrate **25** in a position corresponding to the through hole **24** of the mask **41.** The holing process may be carried out by pressing or the like.

Next, as shown in FIG. **17(c),** the mask **41** is removed from the insulating substrate 25, and the resist **78** is cured. The resist **78** is cured, for example, at 90 through 130°C for 1 through 15 minutes.

Then, as shown in FIG. **17(d),** the conducting layer **79** is etched by using the resist **78** as a mask (guide), and thereafter, the resist **78** is removed. Thus, the control electrode **14** and the wiring part **15** are formed on one face (top face) of the insulating substrate **25.**

Thereafter, a transferring member (not shown) having a resist corresponding to a deflecting electrode **16** and a wiring part **17** is brought into contact with the conducting layer **79** formed on the back face of the insulating substrate **25,** so as to transfer the resist onto the conducting layer **79.** Next, the resist is cured in the same manner as described above, and the conducting layer **79** is etched by using the cured resist as a mask. Then, the resist is removed. Thus, the deflecting electrode **16** and the wiring part **17** are formed on the other face (back face) of the insulating substrate **25.**

Also in this embodiment, it goes without saying that the control electrode **14,** the deflecting electrode **16** and the wiring parts **15** and **17** or the inner wall of the through hole **13** may be covered with an insulating protection film of polyparaxylene, parylene or the like.

Also, the curing resin used for forming the resist is not limited to a thermosetting resin but may be another curing resin such as a UV curing resin and a solvent curing resin.

### - Modifications -

Although the control electrode **14** and the wiring part **15** are formed by using a mask and the deflecting electrode **16** and the wiring part **17** are formed by using a transferring member in each of the aforementioned embodiments, it goes without saying that the deflecting electrode **16** and the wiring part **17** may be formed by using a mask. In other words, a mask can be used as the transferring member. Also, the control electrode **14** and the wiring part **15** may be formed after forming the deflecting electrode **16** and the wiring part **17.** Alternatively, they can be simultaneously formed. In the case where the control electrode **14** and the wiring part **15** are in the same shape as the deflecting electrode **16** and the wiring part **17,** they can be formed by using the same mask.

In each of the aforementioned fabrication methods, a recess can be formed instead of the through hole (passing hole) in the insulating substrate **25** by changing the conditions for the irradiation of the laser beam LL and the like. Specifically, instead of the step for forming the through hole, or in addition to the step for forming the through hole, a step for forming a recess in the insulating substrate **25** may be carried out. In this case, the resultant printed substrate has a recess instead of the through hole or in addition to the through hole.

Furthermore, the insulating substrate **25** is not limited to a single-layer substrate formed from a single material but may be a multi-layer substrate in which a plurality of layers of a plurality of materials are stacked.

The application of the printed substrate of this invention is not limited to a control substrate for use in the toner jet (trademark) printer but may be a control substrate for use not only in a printer but also in a copying machine, a facsimile or the like.

Moreover, the printed substrate of this invention is not limited to a control substrate for controlling the passage of a charged substance but may be an electronic circuit printed substrate used for forming an electronic circuit. Recently, the packaging density of an electronic circuit is increased, and hence, there are demands for improvement in the alignment accuracy between an electrode pattern on a printed substrate and a through hole or the like. When the fabrication method of this invention is employed, an electronic circuit printed substrate with a high density and high quality can be fabricated at low cost and with ease.

### Industrial Applicability

As described so far, the present invention is useful for a printed substrate usable as a developer passage control substrate and various electronic circuit substrates, and a recording apparatus including the printed substrate.

## Claims

1. A method for fabricating a printed substrate comprising:
a step of forming a through hole in a multi-layer substrate including at least first, second and third layers successively stacked;
a step of etching a part of said second layer from an exposed portion thereof within said through hole in a radial direction of said through hole; and
a covering step of covering said exposed portion of said second layer after etching.

2. The method for fabricating a printed substrate of Claim 1,
wherein said covering step includes a step of bringing an opening edge of said first layer around said through hole and an opening edge of said third layer around said through hole into contact with each other, whereby covering said second layer.

3. The method for fabricating a printed substrate of any of Claims 1 and 2,
wherein said first and third layers are formed from insulating layers and said second layer is formed from a conducting layer.

4. A method for fabricating a printed substrate comprising the steps of:
in a multi-layer substrate including a surface layer of a conducting layer and an insulating layer formed on a back face of said surface layer, patterning said surface layer with a part thereof remaining as a remaining portion;
forming, in said multi-layer substrate, an extracted portion formed by extracting a part of said remaining portion and a recess or through hole corresponding to said extracted portion in said insulating layer by extracting said part of said remaining portion of said surface layer and a part or whole, along a thickness direction, of a portion of said insulating layer corresponding to said extracted portion; and
covering at least said extracted portion of said surface layer and a wall of said recess or through hole of said insulating layer with an insulating layer.

5. A method for fabricating a printed substrate comprising the steps of:
in a multi-layer substrate including a surface layer of a conducting layer and an insulating layer formed on a back face of said surface layer, patterning said surface layer with a part thereof remaining as a remaining portion;
forming, in said multi-layer substrate, an extracted portion by extracting a part of said remaining portion of said surface layer and a recess or through hole by extracting a part or whole, in a thickness direction, of a portion of said insulating layer corresponding to said extracted portion by using a mask having an opening smaller than said remaining portion; and
covering at least said extracted portion of said surface layer and a wall of said recess or through hole of said insulating layer with an insulating layer.

6. A method for fabricating a printed substrate comprising the steps of:
in a multi-layer substrate including a surface layer of a conducting layer and an insulating layer formed on a back face of said surface layer, patterning said surface layer with a part thereof remaining as a remaining portion;
forming a through hole penetrating a part of said remaining portion of said surface layer and said insulating layer by punching processing; and
covering at least said surface layer and a wall of said through hole of said insulating layer with an insulating layer.

7. A method for fabricating a printed substrate comprising the steps of:
in a multi-layer substrate including a surface layer of a conducting layer and an insulating layer formed on a back face of said surface layer, patterning said surface layer, whereby exposing a part of said insulating layer;
forming a recess or through hole in an exposed portion of said insulating layer by using said patterned surface layer as a mask; and
covering at least said surface layer and a wall of said recess or through hole with an insulating film by chemical vapor deposition.

8. A method for fabricating a printed substrate including a substrate having a through hole penetrating a top face and a back face thereof, a first control part provided on the top face of said substrate around at least a part of periphery of said through hole, a second control part provided on the back face of said substrate around at least a part of periphery of said through hole and a protection layer covering said first control part and said second control part, comprising:
a control part setting step of providing said first control part on the top face of said substrate and providing said second control part on the back face of said substrate in a position corresponding to said first control part;
a step of covering said control parts by providing said protection layer on the both faces of said substrate;
a step of forming said through hole penetrating said substrate, said control parts and said protection layer;
a step of etching a part of said control parts from an exposed portion thereof within said through hole in a radial direction of said through hole; and
a covering step of covering said control parts with a protection layer after etching.

9. The method for fabricating a printed substrate of Claim 8,
wherein said covering step includes a step of bending opening edges around said through hole of said protection layer provided on the both faces of said substrate toward said substrate, whereby covering said first and second control parts with said opening edges.

10. A method for fabricating a printed substrate including a substrate having a through hole penetrating a top face and a back face thereof, a first control part provided on the top face of said substrate around at least a part of periphery of said through hole, a second control part provided on the back face of said substrate around at least a part of periphery of said through hole and a protection layer covering said first control part and said second control part, comprising:
a control part setting step of providing said first control part on the top face of said substrate and providing said second control part on the back face of said substrate in a position corresponding to said first control part;
a step of forming said through hole penetrating said substrate and said control parts; and
a step of providing said protection layer on said control parts and a wall of said through hole of said substrate by chemical vapor deposition.

11. A method for fabricating a printed substrate including a substrate having a through hole penetrating a top face and a back face thereof, a first control part provided on the top face of said substrate around at least a part of periphery of said through hole, a second control part provided on the back face of said substrate around at least a part of periphery of said through hole and a protection layer covering said first control part and said second control part, comprising:
a control part setting step of providing said first control part in a ring or arch shape on the top face of said substrate and providing said second control part in a ring or arch shape on the back face of said substrate in a position corresponding to said first control part;
a step of forming said through hole in said substrate by using a mask having an opening with an inner diameter smaller than an outer diameter of the ring or arch shape of said first control part; and
a step of covering said control parts and a wall of said through hole of said substrate with said protection layer.

12. A method for fabricating a printed substrate including a substrate having a through hole penetrating a top face and a back face thereof, a first control part provided on the top face of said substrate around at least a part of periphery of said through hole, a second control part provided on the back face of said substrate around at least a part of periphery of said through hole and a protection layer covering said first control part and said second control part, comprising:
a control part setting step of providing said first control part on the top face of said substrate and providing said second control part on the back face of said substrate in a position corresponding to said first control part;
a step of forming said through hole penetrating said substrate and said control parts by punching processing; and
a step of covering said control parts and a wall of said through hole of said substrate with said protection layer.

13. A method for fabricating a printed substrate including a substrate having a through hole penetrating a top face and a back face thereof, a first control part provided on the top face of said substrate around at least a part of periphery of said through hole, a second control part provided on the back face of said substrate around at least a part of periphery of said through hole and a protection layer covering said first control part and said second control part, comprising:
a control part setting step of providing said first control part in a ring or arch shape on the top face of said substrate and providing said second control part in a ring or arch shape on the back face of said substrate in a position corresponding to said first control part;
a step of forming said through hole in said substrate with said first control part used as a mask; and
a step of providing said protection layer on said control parts and a wall of said through hole of said substrate by chemical vapor deposition.

14. The method for fabricating a printed substrate of any of Claims 8 through 13,
wherein the control part setting step includes:
a step of forming surface layers on the top face and the back face of said substrate; and
a step of forming said first control part and said second control part from remaining portions of said surface layers by etching part of said surface layers.

15. The method for fabricating a printed substrate of any of Claims 8 through 13,
wherein said substrate and said protection layer are made from insulating materials, and
said first control part and said second control part are made from conducting materials.

16. A method for fabricating a recording apparatus,
said recording apparatus including:
developer carrying means for carrying and transferring a charged developer;
a rear electrode for generating electrostatic force for absorbing said developer carried by said developer carrying means; and
a printed substrate provided between said developer carrying means and said rear electrode and including an insulating substrate having a passing hole for allowing said developer from said developer carrying means to pass therethrough, a first electrode provided on said insulating substrate for controlling passage of said developer through said passing hole in accordance with a control signal and a second electrode provided on said insulating substrate for deflecting or converging said developer passing through said passing hole,
said printed substrate being fabricated by the method for fabricating a printed substrate of Claim 15 with said first control part formed as said first electrode and said second control part formed as said second electrode in arch-shaped opposing portions opposing each other.

17. A method for fabricating a printed substrate including an insulating substrate having a through hole, a first control part with a conducting property provided on a top face of said insulating substrate around periphery of said through hole and a second control part with a conducting property provided on a back face of said insulating substrate around periphery of said through hole, comprising a step of:
covering an inner wall of said through hole with an insulating film by chemical vapor deposition after forming said through hole penetrating said first control part, said insulating substrate and said second control part.

18. A method for fabricating a printed substrate by using a mask having a through hole penetrating a top face and a back face thereof and having a groove on one face thereof around at least a part of periphery of said through hole, comprising:
a holding step of allowing an ink to be held in said groove of said mask;
a transferring step of transferring said ink held in said groove onto a base member by placing said mask on a face of said base member; and
a space forming step of forming a recess or through hole in said substrate through said mask by using said through hole of said mask as a guide simultaneously with or after the transferring step.

19. A method for fabricating a printed substrate by using a mask having a through hole penetrating a top face and a back face thereof and having a print portion capable of printing an ink on one face thereof around at least a part of periphery of said through hole, comprising:
a printing step of offsetting said ink on said print portion of said mask;
a transferring step of transferring said ink offset on said print portion onto a base member by placing said mask on a face of said base member after the printing step; and
a space forming step of forming a recess or through hole in said substrate through said mask by using said through hole of said mask as a guide simultaneously with or after the transferring step.

20. A method for fabricating a printed substrate by using a mask having a through hole penetrating a top face and a back face thereof and having a holding portion capable of holding a curing resin on one face thereof around at least part of periphery of said through hole, comprising:
a holding step of allowing said curing resin to be held by said holding portion of said mask;
a transferring step of transferring said curing resin held by said holding portion onto a surface layer formed from a material on a base member by placing said mask on a surface of said surface layer;
a space forming step of forming a recess or through hole in said base member through said mask by using said through hole of said mask as a guide simultaneously with or after the transferring step; and
a step of removing a part of said surface layer by using said transferred curing resin as a guide after the space forming step.

21. The method for fabricating a printed substrate of any of Claims 18 through 20,
wherein the space forming step includes a step of forming a through hole in said base member, and
said method further includes a step of placing a transferring member, having a through hole in the same shape as said through hole and having a groove for holding an ink on one face in a position around said through hole, on a back face of said base member with said through hole of said base member overlapping said through hole of said transferring member, and transferring said ink held in said groove onto a position on the back face of said base member.

22. The method for fabricating a printed substrate of any of Claims 18 through 20,
wherein the space forming step includes a step of forming a through hole in said base member, and
said method further includes a step of placing a transferring member, having a through hole in the same shape as said through hole and holding an ink on one face in a position around said through hole, on a back face of said base member with said through hole of said base member overlapping said through hole of said transferring member, and transferring said ink onto a position on the back face of said base member.

23. The method for fabricating a printed substrate of any of Claims 18 through 20,
wherein the space forming step includes a step of forming a through hole in said base member, and
said method further includes the steps of:
forming a surface layer of a material on a back face of said base member;
placing a transferring member, having a through hole in the same shape as said through hole and having a curing resin on one face thereof in a position around said through hole, on said surface layer with said through hole of said base member overlapping said through hole of said transferring member and transferring said curing resin onto said surface layer; and
removing a part of said surface layer by using said transferred curing resin as a guide.

24. The method for fabricating a printed substrate of any of Claims 18 through 20,
wherein said base member is made from an insulating substrate and said ink is made from a conducting material,
and
said ink transferred onto said insulating substrate forms an electrode.

25. The method for fabricating a printed substrate of Claim 20,
wherein said base member is made from an insulating substrate and said surface layer is made from a conducting material, and
a portion of said surface layer remaining on said insulating substrate forms an electrode.

26. The method for fabricating a printed substrate of Claim 24, further comprising a step of forming an insulating layer for covering said electrode at least on the top face and the back face of said insulating substrate.

27. A method for fabricating a recording apparatus,
said recording apparatus including:
developer carrying means for carrying and transferring a charged developer;
a rear electrode for generating electrostatic force for absorbing said developer carried by said developer carrying means; and
a printed substrate provided between said developer carrying means and said rear electrode and including an insulating substrate having a passing hole for allowing said developer from said developer carrying means to pass therethrough, a first electrode for controlling passage of said developer through said passing hole in accordance with a control signal and a second electrode for deflecting or converging said developer passing through said passing hole,
said printed substrate being fabricated by the method for fabricating a printed substrate of Claim 26 with an electrode formed on the top face of said insulating substrate formed as said first electrode and an electrode formed on the back face of said insulating substrate formed as said second electrode.

28. A mask for use in fabrication of a printed substrate comprising:
a through hole penetrating a top face and a back face thereof; and
a groove capable of holding an ink formed on one face thereof around at least a part of periphery of said through hole.

29. A mask for use in fabrication of a printed substrate comprising:
a through hole penetrating a top face and a back face thereof; and
a holding portion capable of holding an ink formed on one face thereof around at least a part of periphery of said through hole.

30. A mask for use in fabrication of a printed substrate comprising:
a through hole penetrating a top face and a back face thereof; and
a holding portion capable of holding a curing resin on one face thereof around at least a part of periphery of said through hole.
